Europäisches Patentamt

European Patent Office

Office européen des brevets

(11) Veröffentlichungsnummer: **0 282 820**
**A1**

## (12) EUROPÄISCHE PATENTANMELDUNG

(21) Anmeldenummer: 88103209.8

(22) Anmeldetag: 02.03.88

(51) Int. Cl.⁴: **H01L 21/31 , H01L 21/60**

(30) Priorität: 13.03.87 DE 3708277

(43) Veröffentlichungstag der Anmeldung:
**21.09.88 Patentblatt 88/38**

(84) Benannte Vertragsstaaten:
**AT BE CH DE FR GB IT LI NL SE**

(71) Anmelder: **Siemens Aktiengesellschaft Berlin und München**
**Wittelsbacherplatz 2**
**D-8000 München 2(DE)**

(72) Erfinder: **Grewal, Virinder, Dr.-Ing.**
**Karwendelstrasse 45**
**D-8017 Ebersberg(DE)**
Erfinder: **Mokrisch, Peter, Dipl.-Ing.**
**Josephsburgstrasse 46**
**D-8000 München 80(DE)**
Erfinder: **Erb, Hans-Peter, Dr.rer.nat.**
**Zechstrasse 45**
**D-8026 Ebenhausen(DE)**

(54) **Verfahren zum Erzeugen von Kontaktlöchern mit abgeschrägten Flanken in Zwischenoxidschichten.**

(57) Kontaktlöcher (5) mit abgeschrägten Flanken (6) in Zwischenoxidschichten (2) werden dadurch erhalten, daß beim Trockenätzen in fluorhaltigem Plasma eine Kombination isotroper und anisotroper Ätzschritte mit unterschiedlichen Ätzraten durchgeführt wird. Dabei wird vor dem Erzeugen der Photolackmaske (4) ganzflächig eine Hilfsschicht (3) aus einem siliziumoxidhaltigen Material aufgebracht und die Anordnung überwiegend isotrop bis etwa zur halben Ätztiefe der Zwischenoxidschicht (2) geätzt und dann anisotrop die restliche Zwischenoxidschicht (2) selektiv zur darunterliegenden, die zu kontaktierende Oberfläche enthaltenden Schicht (1) geätzt. Die Hilfsschicht (3) wird mit der Photolackmaske (4) entfernt. Mit dem erfindungsgemäßen Verfahren lassen sich Flankenwinkel (6) in Kontaktlöchern (5) kleiner 90° reproduzierbar herstellen. Das Verfahren wird verwendet bei der Herstellung von höchstintegrierten Halbleiterschaltungen.

## Verfahren zum Erzeugen von Kontaktlöchern mit abgeschrägten Flanken in Zwischenoxidschichten.

Die Erfindung betrifft ein Verfahren zum Erzeugen von Kontaktlöchern mit abgeschrägten Flanken in aus $SiO_2$ bestehenden Isolationsschichten, wie sie als Zwischenoxidschichten bei der Herstellung hochintegrierter Halbleiterschaltungen verwendet werden, durch Trockenätzen unter Verwendung einer Photolackmaske in einem fluorhaltige Ätzmittel enthaltenden Plasma, bei dem isotrope und anisotrope Ätzschritte mit unterschiedlichen Ätzraten aufeinanderfolgend durchgeführt werden.

Die in der VLSI-Technologie (= very large scale integration) auftretenden Stufen zwischen den verschiedenen Verdrahtungsebenen (Polysilizium 1, Polysilizium 2 und Aluminiumleiterbahnebene) erfordern ein Einebnen des Zwischenoxids mit guten Fließeigenschaften bereits bei niedrigen Temperaturen, um eine unproblematische Kantenbedeckung an den auftretenden Stufen zu gewährleisten. Phosphor-bzw. Bor-dotiertes Silikatglas (BSG, PSG bzw. PBSG) erfüllt diese Forderungen sehr gut.

In diese, als Zwischenoxid bezeichneten Schichten müssen unterschiedlich tiefe Kontaktlöcher geätzt werden. Um eine gute Metallkantenbedeckung auch der tiefsten Löcher zu gewährleisten, ist die Entwicklung eines Kontaktloch-Ätzverfahrens notwendig.

Aufgabe der Erfindung ist es, ein solches Verfahren anzugeben, wobei folgende Forderungen erfüllt werden sollen:

1. Das Verfahren soll möglichst in einer Trockenätzanlage durchführbar sein.

2. Der Flankenwinkel soll reproduzierbar zwischen 30° und 90° ohne scharfe Übergänge vom oberen Teil der Abschrägung (30 bis 45°) zum unteren Teil (90°) einstellbar sein.

3. Die Ätzung soll gleichmäßig (kleiner ± 5 %) auf der ganzen Siliziumkristallscheibe erfolgen.

4. Die Kontaktlöcher sollen am Fußpunkt gut maßhaltig sein.

5. Die Selektivität zwischen dem Oxid und dem darunterliegenden polykristallinen Silizium soll im Verhältnis von 10 : 1, zwischen dem Oxid und dem als Ätzmaske dienenden Photolack im Verhältnis von 4 : 1 sein.

6. Das aus einkristallinem Silizium bestehende Substrat soll möglichst nicht geschädigt werden.

7. Photolack-und Ätzrückstände sollen problemlos entfernbar sein.

Aus einem Bericht von I. S. Chang aus dem Solid State Technology/April 1984, Seiten 214 bis 219 und einem Bericht von Choe, Knapp und Jacob aus der gleichen Zeitschriften, Seiten 177 bis 183, sind Verfahren zum Abschrägen von Kontaktlochflanken (sogenannten sloped walls) über den Photolackabtrag bekannt. Das Prinzip dieser Verfahren liegt in der gleichzeitigen Erosion des geflossenen Photolackes während der anisotropen Oxidätzung mit Trifluormethan ($CHF_3$ ) bzw. Mischungen aus Trifluormethan und Sauerstoff als Ätzgas. Durch die Menge der Sauerstoffzugabe wird die Erosionsrate des Lackes bestimmt.

Bei Siliziumkristallscheiben, die in der VLSI-Technik verarbeitet werden, treten große topographische Unterschiede auf, so daß die sogenannte trilevel-Technik verwendet werden muß. Diese beruht darauf, daß zuerst eine einebnende relativ dicke (ca. 1,5 bis 2,5 μm) Lackschicht auf die Siliziumscheibe aufgebracht wird. Auf diese wird eine SOG-Schicht (= spin-on Glas) und darauf eine Photolackschicht aufgebracht. Nach dem Belichten und Entwickeln der Photolackschicht wird die SOG-Schicht anisotrop geätzt. Diese SOG-Schicht dient als Maske für die Strukturierung der Lackschicht in einem reaktiven Ionenätz-Plasma mit Sauerstoff. Der Prozeß der Erzeugung abgeschrägter Flanken bei der Kontaktlochätzung über dem Photolackabtrag kann deshalb hier nicht eingesetzt werden.

Die Kombination zwischen naßchemischen isotropen und anisotropen Trockenätzprozessen hat den Nachteil, daß bei den naßchemischen Verfahren die Oxid-Ätzrate stark von der Dotierung abhängig ist. Hier ist oft die laterale Ätzrate um vieles größer als die vertikale Ätzrate. Für eine gute Abschrägung mit den obengenannten Forderungen ist auch dieser Prozeß nur bedingt einsetzbar.

In der deutschen Patentanmeldung P 36 15 519.5 ist schließlich ein Verfahren der eingangs genannten Art vorgeschlagen worden, bei dem Kontaktlöcher mit abgeschrägten Flanken in Zwischenoxidschichten dadurch erhalten werden, daß beim Trockenätzen in fluorhaltigem Plasma eine Kombination isotroper und anisotroper Ätzschritte durchgeführt wird, wobei beginnend mit einem isotropen Ätzschritt ein solches Ätzgasgemisch verwendet wird, in dem die Konzentration freier Fluor-Atome für den isotropen Ätzschritt zugunsten freier $CF_3$ -Radikale und -Ionen für den anisotropen Ätzschritt verschoben wird. Der letzte Ätzschritt erfolgt anisotrop. Gleichzeitig wird während des Ätzprozesses der Elektrodenabstand im Reaktor vermindert. Auch bei diesem Verfahren entsteht eine scharfe Kante (90°) am oberen Teil der Flanke und eine scharfe Kante (kleiner 90°) im mittleren Teil der Flanke. Daher ist auch bei diesem Verfahren die nachfolgende Metallisierung problematisch. Bei starker Abschrägung wird außerdem der Isolationsabstand zu benachbarten tiefer liegenden Leitungsebenen zu klein, so daß auch dieses Verfahren nur bedingt einsetzbar ist.

Die Erfindung löst das Problem der idealen Kontaktlochabschrägung durch ein Verfahren der eingangs genannten Art, welches durch folgende Verfahrensschritte gekennzeichnet ist:

a) vor dem Erzeugen der Photolackmaske wird auf die Isolationsschicht ganzflächig eine Hilfsschicht aus einem Siliziumoxid enthaltenden Material aufgebracht,

b) die Photolackmaske wird erzeugt und die Doppelschicht: Hilfsschicht/Isolationsschicht wird überwiegend isotrop bis etwa zur halben Ätztiefe der Isolationsschicht geätzt,

c) die verbleibende Isolationsschicht wird dann anisotrop selektiv bis zur darunterliegenden, die zu kontaktierende Oberfläche enthaltenden Schicht geätzt und

d) abschließend wird die Hilfsschicht mit der darüber befindlichen Photolackmaske entfernt.

Es liegt im Rahmen der Erfindung, daß als Hilfsschicht eine ca. 50 nm dicke Schicht aus Spin-on-Glas oder Siliziumoxinitrid und als Isolationsschicht eine aus Bor-Phosphor-Silikatglas bestehende Schicht verwendet wird.

Weitere Ausgestaltungen der Erfindung ergeben sich aus den Unteransprüchen.

Durch die Erfindung wird folgendes erreicht:

Die entstehenden Flankenwinkel und Kanten sind abhängig vom Verhältnis der isotropen und anisotropen Komponenten der Ätzraten der Hilfsschicht und der Isolationsschicht. Die Kanten der Flanken sind in jedem Falle kleiner 90°, und die Flanke wird von oben nach unten immer steiler, so daß eine bessere Kantenbedeckung der nachfolgenden Metallisierung erreicht wird. Durch die zunehmende Steilheit der Flanke ist außerdem ein optimaler Isolationsabstand zu benachbarten, etwas tiefer liegenden Leitungsebenen gewährleistet.

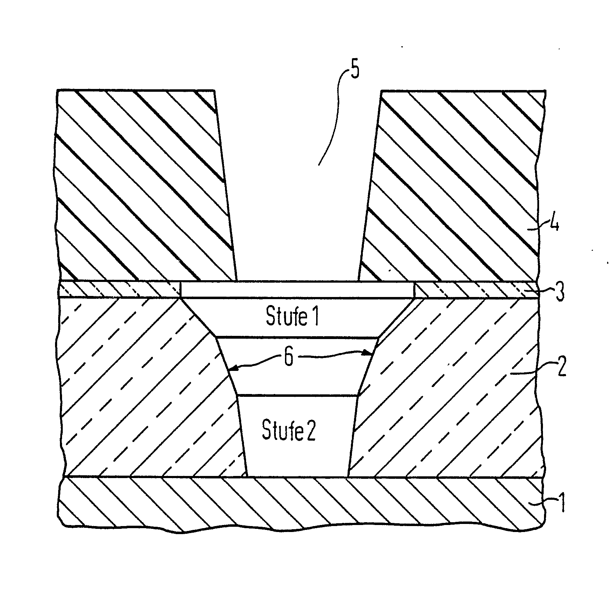

Nähere Einzelheiten über die Durchführung des erfindungsgemäßen Verfahrens werden anhand eines Ausführungsbeispiels und der in der Zeichnung befindlichen Figur, welche dem Simulationsmodell eines Ätzprofils entnommen wurde, beschrieben. Die Figur zeigt im Schnittbild die zu ätzende Schichtenfolge für die Herstellung des Kontaktloches mit abgeschrägten Flanken.

Der Prozeß kann als 2-Stufen-Prozeß mit Änderung der Gasmischung und des Elektrodenabstandes in einem Einscheiben-Plattenreaktor (wie er beispielsweise von der Firma Lam Research Corporation angeboten wird) durchgeführt werden.

In der Figur ist mit dem Bezugszeichen 1 das polykristalline Silizium (zum Beispiel die Oberfläche einer Gateelektrode), mit 2 die aus Bor-Phosphor-Silikatglas bestehende Zwischenisolationsschicht (Schichtdicke 800 nm), mit 3 die zum Beispiel aus Spin-on-Glas bestehende Hilfsschicht (50 nm), mit 4 die Photolackmaske (1300 nm), mit 5 das Kontaktloch und mit 6 seine abgeschrägten Flanken bezeichnet.

Folgende Parameter werden eingestellt:

Stufe 1- Teilweise isotrope Ätzung der Doppelschicht 2, 3 bis zur halben Ätztiefe der Bor-Phosphor-Silikatglasschicht 2:

Druck:     600 Pa
HF-Leistung:     700 W
Elektrodenabstand:     2,5 cm
Temperatur:     8 °C
Tetrafluorkohlenstofffluß:     100 sccm
Sauerstofffluß:     4 sccm
Trifluorammoniakfluß:     6 sccm
Ätzzeit:     70 sec

Ätzraten Bor-Phosphor-Silikatglas 2 (4 % B; 4 % P):

vertikal:     360 nm/min
lateral:     250 nm/min

Ätzraten Spin-on-Glas 3:

vertikal:     550 nm/min
lateral:     300 nm/min

Ätzraten Photolack 4:
vertikal:     250 nm/min
lateral:     kleiner 50 nm/min

Die Gleichmäßigkeit über die Scheibe ist besser als ± 5 %.

Stufe 2:- Anisotrope Ätzung der verbleibenden Phosphor-/Bor-PhosphorSilikatglasschicht 2, selektiv zum darunterliegenden Silizium 1, ohne dessen Schädigung:

Druck:     375 Pa
HF-Leistung:     750 W
Elektrodenabstand:     0,36 cm
Temperatur:     8 °C
Tetrafluorkohlenstofffluß:     25 sccm
Trifluormethanfluß:     28 sccm
Heliumfluß:     100 sccm

Ätzrate Bor-Phosphor-Silikatglas 2 (vertikal) 400 nm/min

Ätzrate Photolack 4     (vertikal)kleiner 50 nm/min

Die Gleichmäßigkeit über die Scheibe ist besser als ± 5 %.

Die Selektivität Bor-Phosphor-Silikatglas (2)-/polykristallines Silizium (1) ist größer 10 : 1.

Wie aus dem in der Figur dargestellten Ätzprofil zu entnehmen ist, sind die Kanten der Flanken 6 kleiner 90° und die Flanken werden von oben nach unten immer steiler, so daß eine gute Kantenbedeckung der nachfolgenden Metallisierung (nicht dargestellt) gewährleistet ist. Durch die zunehmende Steilheit der Flanken 6 wird ein optimaler Isolationsabstand zur etwas tiefer liegenden Leitungsebene (nicht dargestellt) gewährleistet.

**Ansprüche**

1. Verfahren zum Erzeugen von Kontaktlöchern (5) mit abgeschrägten Flanken (6) in aus $SiO_2$ bestehenden Isolationsschichten (2), wie sie als Zwischenoxidschichten bei der Herstellung hochintegrierter Halbleiterschaltungen verwendet werden, durch Trockenätzen unter Verwendung einer Photolackmaske (4) in einem fluorhaltige Ätzmittel enthaltendem Plasma, bei dem isotrope und anisotrope Ätzschritte mit unterschiedlichen Ätzraten aufeinanderfolgend durchgeführt werden, **dadurch gekennzeichnet, daß**

a) vor dem Erzeugen der Photolackmaske (4) auf die Isolationsschicht (2) ganzflächig eine Hilfsschicht (3) aus einem Siliziumoxid enthaltenden Material aufgebracht wird,

b) die Photolackmaske (4) erzeugt und die Doppelschicht (2, 3) Hilfsschicht/Isolationsschicht überwiegend isotrop bis etwa zur halben Ätztiefe der Isolationsschicht (2) geätzt wird,

c) dann die verbleibende Isolationsschicht (2) anisotrop selektiv bis zur darunterliegenden, die zu kontaktierende Oberfläche enthaltende Schicht (1) geätzt wird und

d) abschließend die Hilfsschicht (3) mit der darüber befindlichen Photolackmaske (4) entfernt wird.

2. Verfahren nach Anspruch 1, **dadurch gekennzeichnet**, daß als Hilfsschicht (3) eine ca. 50 nm dicke Schicht aus Spin-on-Glas oder Siliziumoxinitrid verwendet wird.

3. Verfahren nach Anspruch 1 oder 2, **dadurch gekennzeichnet**, daß als Isolationsschicht (2) eine aus Bor-Phosphor-Silikatglas bestehende Schicht verwendet wird.

4. Verfahren nach einem der Ansprüche 1 bis 3, **dadurch gekennzeichnet**, daß bei der isotropen Ätzung der Doppelschicht (2, 3) als Ätzgas Tetrafluorkohlenstoff ($CF_4$) und Sauerstoff mit oder ohne $NF_3$ gemischt verwendet wird, der Druck im Reaktor auf 600 Pa und der Elektrodenabstand auf 2,5 cm eingestellt wird.

5. Verfahren nach Anspruch 4. **dadurch gekennzeichnet**, daß der Gasfluß Tetrafluorkohlenstoff ($CF_4$) : (Trifluorammoniak ($NF_3$) + Sauerstoff) auf 100 : 10 sccm eingestellt wird.

6. Verfahren nach einem der Ansprüche 1 bis 5, **dadurch gekennzeichnet**, daß bei der anisotropen Ätzung der Isolationsschicht (2) als Ätzgas Tetrafluorkohlenstoff ($CF_4$) mit Trifluormethan ($CHF_3$) und Helium gemischt verwendet wird, der Druck im Reaktor auf 375 Pa und der Elektrodenabstand auf 0,36 cm eingestellt wird.

7. Verfahren nach Anspruch 6, **dadurch gekennzeichnet**, daß der Gasfluß Tetrafluorkohlenstoff ($CF_4$) : Trifluormethan ($CHF_3$) : Helium auf 25 : 28 : 100 sccm eingestellt wird.

8. Verfahren nach einem der Ansprüche 1 bis 7, **dadurch gekennzeichnet**, daß die gemeinsame Entfernung der Photolackmaske (4) mit der Hilfsschicht (3) auf naßchemischem Wege erfolgt.

9. Verfahren nach einem der Ansprüche 1 bis 7, **dadurch gekennzeichnet**, daß die gemeinsame Entfernung der Photolackmaske (4) mit Hilfsschicht (3) durch Plasmaätzen erfolgt.

10. Verfahren nach einem der Ansprüche 1 bis 9, **dadurch gekennzeichnet**, daß eine Einzelscheiben-Ätzanlage mit ein oder zwei Parallelplatten-Reaktoren verwendet wird.

Stufe 1

Stufe 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | EP-A-0 127 946 (BRITISH TELECOMMUNICATIONS) * Ansprüche 1,2,4 * --- | 1 | H 01 L 21/31 H 01 L 21/60 |
| Y | IEE PROCEEDINGS SECTION A-I, Band 133, Nr. 1, Teil I, Februar 1986, Seiten 13-17, Hitchins, Herts, GB; Y.I. CHOI et al.: "Taper etching of the thermal oxide layer" * Seite 13, Zeile 24 - Seite 14, Zeile 22 * | 1 | |
| A | IDEM --- | 2,3 | |
| A,P D | DE-A-3 615 519 (SIEMENS) * Das ganze Dokument * --- | 4-7,10 | |
| A | EP-A-0 030 116 (FUJITSU) * Ansprüche 1,5 * --- | 1,3,4,6 | |
| A | EP-A-0 137 927 (IBM) * Seite 12, Zeilen 20-25 * --- | 9 | RECHERCHIERTE SACHGEBIETE (Int. Cl.4) |
| A | DE-A-3 215 411 (LICENTIA PATENT-VERWALTUNGS) * Ansprüche 1,2 * ----- | 1,10 | H 01 L |

Der vorliegende Recherchenbericht wurde für alle Patentansprüche erstellt

| Recherchenort | Abschlußdatum der Recherche | Prüfer |
|---|---|---|
| DEN HAAG | 21-06-1988 | PHEASANT N.J. |